# EUROPEAN PATENT APPLICATION

(11) **EP 1 972 898 A1**
(43) Date of publication of application: **24.09.2008**
(21) Application number: 07102960.7
(22) Date of filing: 23.02.2007
(51) Int. Cl.: G01D 3/036, G01D 5/20, G01R 1/44, G01R 27/26

(54) **Temperature compensated inductance measurement**

(71) Applicant: SEM Aktiebolag, 662 00 Åmål (SE)
(72) Inventor: Olsson, Johan, 662 91, Åmål (SE)
(74) Representative: Edlund, Fabian

(57) **Abstract**

The present invention relates to a method for providing a temperature compensated measurement of the inductance of a coil (16) in an inductive position sensor, the inductance of the coil (16) being an indication of a position to be measured. The method comprises: charging the coil (16) with a charging current by means of a current generator (10); discharging the coil subsequent to the charging by means of a discharging circuit (34), wherein a discharge time (Lₜ) of the discharging is a measure of the inductance of the coil (16); and adjusting the charging current in relation to the resistance (Rᵢ) of the coil (16) so as to compensate for energy losses due to temperature induced resistance (Rᵢ) variations in the coil (16) during the discharging.

The present invention also relates to a corresponding circuit.

## Description

### Technical field of the invention

The present invention relates to a method and circuit for providing a temperature compensated measurement of the coil inductance in an inductive position sensor.

### Background art

Inductive position sensors are used in applications where a need for detecting the position of a component exists, for example in actuators. The sensor is typically represented by a coil comprising a moveable core, where the position of the component is reflected on the position of the core within the coil, which in turn affects the inductance of the coil. Therefore, by measuring the inductance of the inductive position sensor, the position of the coil and subsequently the position of the component is detectable.

There are numerous of electronic circuits which function on the basis of different operating principles for measuring or evaluating the inductance. US4649341 for instance discloses several types of control circuits for inductive sensors, where a voltage pulse is applied to a coil causing the current through the coil to rise. In one embodiment, the time period for the current to rise from a zero level to a predetermined limit is measured using a microcomputer and represents the inductance of the coil. In another embodiment, the discharge time following current charging for a predetermined time duration is measured, correspondingly representing the inductance of the coil.

However, with ambient temperature fluctuations, modified physical conditions for the circuit are introduced, as the resistance within the inductive position sensor varies with temperature, resulting in inaccurate position measurements. Consequently, the discussed circuits have the disadvantage of not satisfactory compensate ambient temperature fluctuations, as the charging time of the coil is affected by variation in temperature, which subsequently affects the core displacement measurement.

To this end, methods and arrangements to overcome the temperature influence on the measurement accuracy are known as prior art. US5332966 for instance discloses a "method for compensating temperature fluctuations of inductive sensors having at least one coil from the inductance of which an output variable is formed as measure for a physical variable to be measured, a variable which is dependent on the resistance of the coil is measured and used for correction upon the forming of the output variable".

Thus, in this method, post processing of the output is necessary, requesting the presence of a microcontroller with an A/D converter. Also, in US5332966, the voltage variation over time is measured, which is difficult to achieve with high accuracy.

### Summary of the invention

It is an object of the invention to provide an improved method and circuit to overcome or at least alleviate some of the drawbacks in prior art solutions regarding the influence of temperature in an inductive position sensor.

According to one aspect of the present invention, this and other objects that will be apparent from the following description are achieved by a method for providing a temperature compensated measurement of the inductance of a coil in an inductive position sensor, the inductance of the coil being an indication of a position to be measured, comprising: charging the coil with a charging current by means of a current generator; discharging the coil subsequent to the charging by means of a discharging circuit, wherein a discharge time of the discharging is a measure of the inductance of the coil; and during the charging, adjusting the charging current in relation to the resistance of the coil so as to compensate for energy losses due to temperature induced resistance variations in the coil during the discharging.

At the end of the charging phase, there is a certain energy stored in the coil. However, during the subsequent discharging, some of this energy may be lost due to the resistance of the coil, the amount of energy lost depending the temperature (which affects the resistance), resulting in that not all energy is transferred to the discharging circuit. This in turn may affect the discharging time (increased temperature means too short discharging time), which may lead to an incorrect measure of the inductance, whereby the indication of the position to be measured becomes erroneous. To this end, the present invention is based on the understanding that the energy losses due to temperature induced resistance variations in the coil during the discharge phase may be compensated by adjusting the charging current (during the charging phase) in relation thereto. For instance, at a higher temperature, the resistance of the coil increases causing losses during discharging, whereto the charging current is increased accordingly so that more energy is put into the coil to compensate for the subsequent increased energy loss over the resistance during discharge. Contrary, at a lower temperature, the resistance of the coil decreases, and the charging current is adjusted accordingly. The result is a more accurate discharge time, and consequently a more accurate measure of the inductance and position in question. Further, no post processing after the discharging to account for temperature fluctuations is necessary. Preferably, the adjustment of the charging current is proportionally to the resistance of the coil, i.e. the charging current increases with temperature, to compensate for the energy losses.

Preferably, the charging current is adjusted based on an input to the current generator, said input being related to a fraction of the charging voltage of the coil, and said fraction being dependent on the resistance of the coil (which in turn depends on temperature). Thus, part of the charging voltage is used for a feedback in a loop to the current generator. For instance, at a higher temperature, the resistance of the coil increases, whereby the fraction of the charging voltage that is fed back increases, which in turn leads to an increased charging current to compensate for energy losses in the discharge phase. Overall, an optimal charging current adjustment may be achieved more or less automatically.

In a preferred embodiment, the current generator is an operational amplifier. Preferably, said fraction of the charging voltage is input to a non-inverting input of the operational amplifier, representing the desired value or set point of the charging current, while the input on a corresponding inverting input of the operational amplifier represents the actual value of the charging current (positive feedback control). Such an arrangement is effective and cost efficient. Further, the discharging circuit is preferably adapted to provide a clamp voltage. The discharging circuit may for example comprise a zener diode. Hereto, said discharging time is the time the zener diode conducts current at an essentially constant voltage. Such a setup provides an accurate measurement for the position to be sensed, since any inaccuracy is limited to the errors and temperature drift of the operational amplifier and the clamping circuit (zener diode).

According to another aspect of the invention, there is provided a circuit for providing a temperature compensated measurement of the inductance of a coil in an inductive position sensor, the inductance of the coil being an indication of a position to be measured, comprising: a current generator for charging the coil with a charging current; a discharging circuit for discharging the coil subsequent to the charging, wherein a discharge time of the discharging is a measure of the inductance of the coil; and means for adjusting the charging current in relation to the resistance of the coil so as to compensate for energy losses due to temperature induced resistance variations in the coil during the discharging.

According yet to another aspect of the invention, there is provided a method for compensating for temperature in an inductive position sensor having a coil, the inductance of which being an indication of a position to be measured, where a current generator is provided for charging the coil with a charging current, a discharging circuit is provided for discharging the coil subsequent to the charging, and a discharge time of the discharging is a measure of the inductance of the coil, the method comprising the step of: adjusting the charging current in relation to the resistance of the coil so as to compensate for energy losses due to temperature induced resistance variations in the coil during the discharging.

These aspects exhibit similar advantages as the previously discussed aspect of the invention.

### Brief description of the drawings

The invention will be more apparent from the accompanying drawings, which are provided by way of nonlimiting examples.

Fig. 1 illustrates a circuit for providing a temperature compensated measurement of the inductance of a coil in an inductive position sensor according to a preferred embodiment of the present invention.

Fig. 2 is a time diagram of voltages of the circuit in figure 1.

### Detailed description of a currently preferred embodiment of the invention

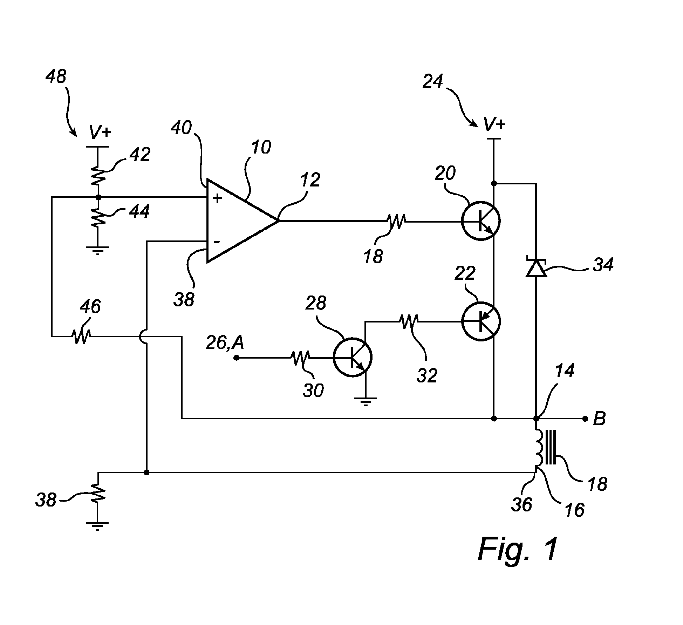

Fig. 1 shows a circuit for providing a temperature compensated measurement of the coil inductance in an inductive position sensor according to a preferred embodiment of the present invention. The circuit is for carrying out the methods according to embodiments and aspects of the invention.

The circuit comprises an operational amplifier 10 serving as a current generator, an output 12 of which is connected to a first side 14 of an inductive coil 16. The coil 16 forms part of the inductive position sensor, which additionally comprises a moveable core 18. The inductance of the coil 16 depends on the position of the moveable core 18 in relation to the coil 16, and the position of the moveable core 18 depends in turn on the position of an object (not shown). Thus, the object's position can generally be determined based on the inductance of the coil 16.

The first side 14 of the inductive coil 16 is connected to the output 12 of the operational amplifier 10 via a resistor 18 and transistors 20, 22. The transistor 20, the remaining electrode of which is connected to a voltage supply 24 (in the order of 5V), serves to increase the current capacity of the operational amplifier 10. On the other hand, the transistor 22 serves to quickly switch on/off the current generator, in order not to loose coil energy in switching losses. Another reason for the transistor 22 is that the current regulator loop should have a low bandwidth to avoid oscillation.

The transistor 22 turns the current generator on/off by controlling the connection between the operational amplifier 10 and the coil 16. To this end, the remaining electrode of the transistor 22 is further connected to an input 26 via a transistor 28 surrounded by resistors 30, 32. When an input signal A on the input 26 is high, the transistors 22 and 28 conduct current, whereby the current generator is active.

The first side 14 of the coil 16 is further connected to a discharging circuit comprising a zener diode 34. A second, opposite side 36 of the coil 16 is connected via a resistor 38 to ground. Additionally, the second side 36 of the coil is connected to an inverting input 38 of the operational amplifier 10. Further, a non-inverting input 40 of the operational amplifier 10 is connected the output of a voltage divider comprising resistors 42, 44 and 46. In the voltage divider, the resistors 42, 44 are connected in series between a voltage source 48 (in the order of 10V) and ground, while the resistor 46 (in the order of 100kΩ) is coupled to the connection between the transistor 22 and the first side 14 of the coil 16.

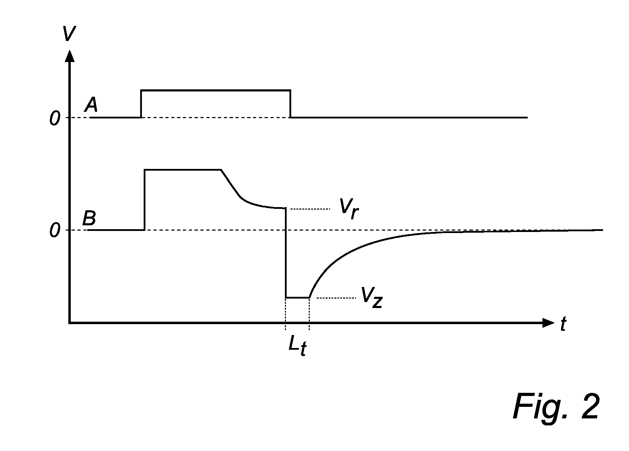

An operation of the circuit of fig. 1 will now be described with additional reference to fig. 2. When the input signal A is high, transistors 28 and 22 conduct current and subsequently the current generator is active (i.e. the coil 16 is charged). The non-inverting input 40 of the operational amplifier 10 (the desired or value or set point of the charging current) is given by the voltage divider comprising the resistors 42, 44, 46, and the inverting input 38 of the operational amplifier 10 (the actual value of the charging current) is given by the voltage across the resistance 38. Such as illustrated in fig. 2, during the charging of the coil 16, the voltage at B (see fig. 1) approaches Vᵣ and the current through the coil 16 approaches a desired magnitude. Hereto, the duration of the charging phase needs to exceed the time which is required for the current to stabilize.

As the input signal A turns low and the current generator is shut off, the charging phase is replaced by a discharging phase. The energy accumulated in the coil 16 is discharged through the zener diode 34 at a constant, and here negative, voltage V_{z} as shown in fig. 2. The discharging time Lₜ is defined as the time the zener diode 14 conducts current (at the constant voltage), which time is proportional to the inductance of the coil 16, and therefore to the position of the movable core 18.

Presuming the coil 16 is regarded as an ideal inductor Lᵢ (not shown) connected in series with an ideal resistor Rᵢ (not shown), it is established that for a temperature interval from -40 to +125 degrees Celsius, Rᵢ may vary about +25%. Such a large resistance interval of Rᵢ could generally effect the measurement in an inductive position sensor. For example if the ambient temperature increases, Rᵢ increases as well, causing a high voltage drop over Rᵢ and therefore an increased voltage level over Lᵢ. This in turn results in that the discharging time Lₜ becomes too short, whereby the measured inductance becomes too low. Consequently, the position to be detected is not detected correctly.

To this end, the present invention has introduced the method and circuit to, during the charging phase, compensate for the influence Rᵢ has during the discharging phase. Hereto, the resistor 46 (the feedback) in the charging phase contributes to adjustment of the non-inverting input 40 (the charging current's desired value) of the operational amplifier 10 proportional to the voltage across the coil 16 and the resistor 38. Thus, if Rᵢ rises, the charging current (the output of the operational amplifier 10) through the coil 16 increases (since the difference between the inputs 40 and 38 increases), effectively compensating and thus eliminating the subsequent temperature influence in the discharging phase.

Applications of the method and circuit of the present invention include inductive position sensors for measuring the position of an actuator. It should however be noted that the method and circuit of the invention could be used also in relation to other inductive components where it is desired to evaluate the component and measure the inductance (the inductance being a measure of a variable to be measured), such as electromagnetic actuators and inductive sensors for detecting/measuring proximity, presence, displacement, speed, angle, etc.

The person skilled in the art realizes that the present invention by no means is limited to the preferred embodiments described above. On the contrary, many modifications and variations are possible within the scope of the appended claims. For instance, the above zener diode 34, which may have a high temperature coefficient, can be replaced by a more advanced voltage reference for improved overall temperature performance.

## Claims

1. A method for providing a temperature compensated measurement of the inductance of a coil (16) in an inductive position sensor, the inductance of the coil (16) being an indication of a position to be measured, comprising:
charging the coil (16) with a charging current by means of a current generator (10);
discharging the coil subsequent to the charging by means of a discharging circuit (34), wherein a discharge time (Lₜ) of the discharging is a measure of the inductance of the coil (16); and
adjusting the charging current in relation to the resistance (Rᵢ) of the coil (16) so as to compensate for energy losses due to temperature induced resistance (Rᵢ) variations in the coil (16) during the discharging.

2. The method according to claim 1, wherein the charging current is adjusted based on an input to the current generator, said input being related to a fraction of the charging voltage of the coil, and said fraction being dependent on the resistance of the coil.

3. The method according to claim 1 or 2, wherein the current generator is an operational amplifier.

4. The method according to any preceding claim, wherein the discharging circuit is adapted to provide a clamp voltage.

5. A circuit for providing a temperature compensated measurement of the inductance of a coil (16) in an inductive position sensor, the inductance of the coil being an indication of a position to be measured, comprising:
a current generator (10) for charging the coil (16) with a charging current;
a discharging circuit (34) for discharging the coil subsequent to the charging, wherein a discharge time (Lₜ) of the discharging is a measure of the inductance of the coil (16); and
means (10; 46) for adjusting the charging current in relation to the resistance (Rᵢ) of the coil (16) so as to compensate for energy losses due to temperature induced resistance (Rᵢ) variations in the coil (16) during the discharging.

6. The circuit according to claim 5, wherein the charging current is adjusted based on an input to the current generator, said input being related to a fraction of the charging voltage of the coil, and said fraction being dependent on the resistance of the coil.

7. The circuit according to claim 6 or 7, wherein the current generator is an operational amplifier.

8. The circuit according to any of claims 5-7, wherein the discharging circuit is adapted to provide a clamp voltage.

9. A method for compensating for temperature in an inductive position sensor having a coil (16), the inductance of which being an indication of a position to be measured, where a current generator (10) is provided for charging the coil (16) with a charging current, a discharging circuit (34) is provided for discharging the coil subsequent to the charging, and a discharge time (Lₜ) of the discharging is a measure of the inductance of the coil (16), the method comprising the step of:
adjusting the charging current in relation to the resistance (Rᵢ) of the coil (16) so as to compensate for energy losses due to temperature induced resistance (Rᵢ) variations in the coil (16) during the discharging.
